# EUROPEAN PATENT APPLICATION

(11) **EP 3 922 755 A1**
(43) Date of publication of application: **15.12.2021**
(21) Application number: 20179696.8
(22) Date of filing: 12.06.2020
(51) Int. Cl.: C23C 22/34, C23C 22/40, C23C 22/46, C23F 1/34, C23F 1/40, C23F 1/46

(54) **AN AQUEOUS BASIC ETCHING COMPOSITION FOR THE TREATMENT OF SURFACES OF METAL SUBSTRATES**

(71) Applicant: Atotech Deutschland GmbH, 10553 Berlin (DE)
(72) Inventor: Kohlmann, Lars, 10553 Berlin (DE); Brunner, Heiko, 10553 Berlin (DE)
(74) Representative: Atotech Deutschland GmbH

(57) **Abstract**

The present invention is directed to an aqueous basic etching composition for the treatment of surfaces of metal substrates, the composition comprising:
(a) functionalized urea, biuret and guanidine derivatives and/or salts thereof selected from the group comprising compounds having formulae I and II and/or salts thereof: 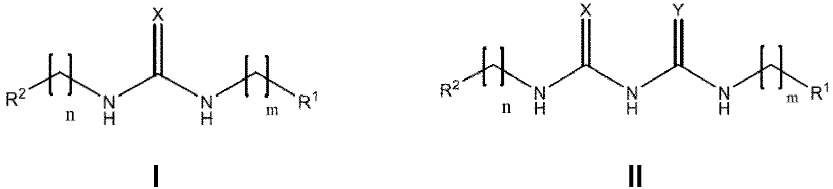 wherein
X and Y are independently selected from the group comprising oxygen, NRR' and NR⁵,
wherein R, R' and R⁵ are independently selected from the group comprising R¹, hydrogen, polyethylene glycoles, aromatic compounds, and C₁-C₄ alkyl, wherein the aromatic compounds and C₁-C₄ alkyl optionally comprise at least one substituent selected as OR⁶,
wherein R⁶ is selected from the group comprising hydrogen and C₁-C₄ alkyl,
wherein X and Y can be identical or different;
R¹ and R² are independently selected from the group comprising hydrogen, alkyl compounds, amines, and nitrogen-comprising heteroaromatic compounds,
wherein R¹ and R² can be identical or different, with the proviso that R¹ cannot be hydrogen;
m is an integer from 1 to 4, preferably 3; and
n is an integer from 0 to 8, preferably 2 to 4;
wherein m and n can be identical or different;

(b) an oxidizing agent for oxidizing the metals of the metal surface to be treated; and
wherein the aqueous basic etching composition comprises a pH from 7.1 to 14.

## Description

### Field of the Invention

The present invention according to a first aspect relates to an aqueous basic etching composition for the treatment of surfaces of metal substrates, in particular for the treatment of silver, copper, nickel and/or cobalt surfaces.

According to a second aspect the present invention is further directed to a method for treating a surface of a metal substrate, in particular silver, copper, nickel and/or cobalt surfaces, with an aqueous basic etching composition according to the first aspect.

According to a third aspect the present invention is further directed to a metal substrate with an etched surface, in particular a silver, copper, nickel and/or cobalt surface, wherein the etched surface of the metal substrate has been obtained by a method for treating a surface of a metal substrate according to the second aspect.

### Background of the Invention

In the production of printed circuit boards, the surface of copper is treated to promote the adhesion between the copper surface and a resist before coating the copper surface with a dry film of etching photoresists, solder resists, etc. The polishing method may include a mechanical polishing such as a buff polishing and a chemical polishing step. In the treatment of substrates carrying fine wiring pattern, the chemical polishing is usually used. In the production of multi-layered printed circuit boards, it has been attempted to promote the adhesion between a copper electroconductive patterned layer and a resin layer, for example, by forming an oxide layer on the copper surface and reducing the oxide layer to metallic copper by a reducing agent while maintaining the geometric shape of the oxide layer.

It is common that copper surfaces upon oxidative treatment become discoloured. A desired colour of an etched copper surface is slightly red to brown and matte. Such a colour is typically associated with a certain roughness which translates into good adhesion of laminates. However, the desired colour change depends also on the application. For copper layers which are present on the outer surface of the laminate reddish colours are desired (for example dry film and solder-resist applications) whereas darker colours may still be acceptable for multilayer applications where treated copper surfaces are kept within an organic matrix. Possible explanations for such a colour changes can also be a thin layer of copper oxide on the surface or the formation of organic copper complexes. Other discolorations are undesired and result in scrap production during manufacturing because many in-line analytical devices focus on the colour of copper surfaces.

A further limitation of many methods described in the art is the occurrence of undesired undercuts when depositing final finishes such as immersion tin or ENIG (electroless nickel immersion gold) onto etched copper surfaces already bearing a solder mask or a photoresist, wherein undercut can be a result of insufficient adhesion between a copper surface and an organic matrix.

Normally, organic matrices deposited onto etched copper surfaces should have rectangular edges. If either the deposition of the organic matrix itself or a metal plating process leaves such edges at odd angles forming a wedge-like form, visible in a cross-section for example, of the organic matrix, then this is referred to as undercut.

US 2018/0312978 A1 discloses a surface treatment solution for copper and copper alloy surfaces and a method for treating copper or copper alloy surfaces. The surface treatment solution comprises an acid and an oxidizing agent selected from group consisting of hydrogen peroxide, metal peroxides, metal superoxides and mixtures thereof, as well as at least one source of chloride ions and at least one source of bromide ions.

WO 02/04706 A1 discloses an acidic treatment liquid and method for treating copper surfaces. The acidic treatment liquid contains hydrogen peroxide and at least one five-membered heterocyclic compound as well as at least one microstructure modifying agent selected from the group comprising thioles, disulfides, sulfides and thioamides.

EP 2 248 402 B1 discloses a non-etching non-resist adhesion composition and method of preparing a work piece. The non-etching non-resist adhesion composition comprises at least one adhesion agent selected from the group comprising heterocyclic compounds comprising at least one thiol moiety, acrylic compounds, and quaternary ammonium polymers.

However, in some conventional methods and treatment solutions it can be not possible to allow for an efficient etching of a wide variety of metal surfaces, for example silver, copper, nickel and/or cobalt surfaces, with an sufficiently efficient etching rate.

Moreover, in some conventional methods and treatment solutions it can be not possible to achieve a sufficiently advantageous roughness of the treated surfaces, which might impair subsequent deposition of additional metals or resin structures onto such etched surfaces.

### Objectives of the present Invention

It was therefore the first objective of the present invention to provide an etching composition and method for the treatment of surfaces of metal substrates, which allow for an efficient etching of the treated metal surfaces, in particular with an effective, in particular constant, etching rate.

It was therefore the second objective of the present invention to provide an etching composition and method for the treatment of surfaces of metal substrates, which can be employed for treating a plurality of different metal or metal alloy surfaces, for example silver, palladium, copper, nickel, cobalt, manganese, zinc, lead, antimony, tin, rare earth metals, for example neodymium, copper-zinc alloy, cupper-tin alloy, copper-nickel alloy, and/or aluminum-magnesium alloy surfaces, in particular silver, copper, nickel and/or cobalt surfaces.

It was therefore the third objective of the present invention to provide an etching composition and method for the treatment of surfaces of metal, which result in an effective roughness of the treated metal surfaces to allow for an efficient, subsequent deposition of additional layer, in particular to create opaque surfaces.

It was therefore the fourth objective of the present invention to provide an etching composition and method for the treatment of surfaces of metal substrates, which can be used for treating a plurality of different metal substrates, for example large-area metal surfaces in the technical field of general manufacturing on the one side and also fine structures on printed circuit boards in the technical field of electronics on the other side.

It was therefore the fifth objective of the present invention to provide an etching composition and method for the treatment of surfaces of metal substrates, wherein the etching composition can be regenerated to allow for an environmentally friendly and cost-effective process.

It was therefore the sixth objective of the present invention to provide an etching composition and method for the treatment of surfaces of metal substrates, wherein the metal ions, which are etched off the respective metal surface, are effectively stabilized in the etching composition to prevent precipitation.

It was therefore the seventh objective of the present invention to provide an etching composition and method for the treatment of surfaces of metal, wherein additional layers, which are subsequently deposited on the treated metal surface have superior functional and/or decorative qualities.

It was therefore the eighth objective of the present invention to provide an etching composition and method for the treatment of surfaces of metal, which contains chemical compounds with a reduced toxicity.

### Summary of the Invention

The first to eighth objectives mentioned above are solved according to a first aspect by an aqueous basic etching composition for the treatment of surfaces of metal substrates, the composition comprising:
(a) functionalized urea, biuret and guanidine derivatives and/or salts thereof selected from the group comprising compounds having formulae I and II and/or salts thereof: 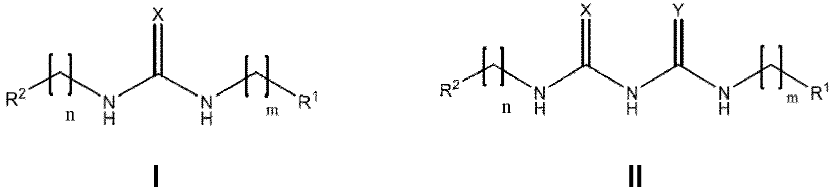 wherein
   X and Y are independently selected from the group comprising oxygen, NRR' and NR⁵,
   wherein R, R' and R⁵ are independently selected from the group comprising R¹, hydrogen, polyethylene glycoles, aromatic compounds, and C₁-C₄ alkyl, wherein the aromatic compounds and C₁-C₄ alkyl optionally comprise at least one substituent selected as OR⁶,
   wherein R⁶ is selected from the group comprising hydrogen and C₁-C₄ alkyl,
   wherein X and Y can be identical or different;
   R¹ and R² are independently selected from the group comprising hydrogen, alkyl compounds, amines and nitrogen-comprising heteroaromatic compounds,
   wherein R¹ and R² can be identical or different, with the proviso that R¹ cannot be hydrogen;
   m is an integer from 1 to 4, preferably 3; and
   n is an integer from 0 to 8, preferably 2 to 4;
   wherein m and n can be identical or different, wherein n and m cannot be 0 at the same time;
(b) an oxidizing agent for oxidizing the metals of the metal surface to be treated; and
   wherein the aqueous basic etching composition comprises a pH from 7.1 to 14, preferably 8 to 12.

The aqueous basic etching composition for the treatment of surfaces of metal substrates allows for an efficient etching of a wide variety of metal surfaces with an optimized etching rate.

In particular, the aqueous basic etching composition allows for an efficient etching of silver, palladium, copper, nickel, cobalt, manganese, zinc, lead, antimony, tin, rare earth metals, for example neodymium, copper-zinc alloy, cupper-tin alloy, copper-nickel alloy, and/or aluminum-magnesium alloy surfaces, in particular silver, copper, nickel and/or cobalt surfaces.

Moreover, the aqueous basic etching composition ensures that an efficient, in particular constant, etching rate is maintained during the etching process. The efficient etching rate allows for an efficient removal of metal from the metal surface during the etching process, which in turn minimizes material consumption. An efficient etching process is in particular characterized by a constant etching rate, which allows for an evenly distributed removal of metal from the metal surface during the etching process, which in turn results in an even metal surface, which can be obtained after the etching process.

Moreover, the aqueous basic etching composition allows for an effective roughness of the treated metal surface, which in turn improves the adhesion of any additional layers, which are subsequently deposited on the treated metal surfaces. Such effective roughness of the treated metal surface can be transmitted to the additionally deposited layer, which consequently also comprise a high roughness, resulting in a desired opaque colour of the additionally deposited layer.

Furthermore, the aqueous basic etching composition can be applied for treating a variety of different metal substrates, such as extended surface areas in the technical field of general manufacturing or finer surface areas, for example printed circuit boards in the technical field of electronics.

Moreover, the functionalized urea, biuret and guanidine derivatives and/or salts thereof selected from the group comprising compounds having formulae I and II of the aqueous basic etching composition allow for an efficient stabilization of the metal ions removed from the treated metal surface within the composition, in particular by chelatization, so that the precipitation tendency of said metal ions can be minimized.

Moreover, the compounds of formulae I and II are less toxic to other etching compounds previously used in the prior art.

An additional particular advantage of the aqueous basic etching composition according to the first aspect is the possibility to regenerate the compounds of said composition to allow for an environmentally friendly and cost-effective process. The first to eighth objectives mentioned above are solved according to a second aspect by a method for treating a surface of a metal substrate, the method comprising the steps:
(A) providing said metal substrate,
(B) providing an aqueous basic etching composition for the treatment of surfaces of metal substrates according to the first aspect, and
(C) contacting the metal substrate with said aqueous basic etching composition such that the surface of the metal substrate is etched.

Said method for treating allows for a superior etching of the surface of the metal substrate to be treated.

The first to eighth objectives mentioned above are solved according to a third aspect by a metal substrate with an etched surface, wherein the etched surface of the metal substrate has been obtained by a method for treating a surface of a metal substrate according to the second aspect.

Said metal substrate provides an effectively etched surface.

### Brief description of the Tables

In Tables 1 and 2, schematic correlations between functionalized urea, biuret and guanidine compounds with varying pH values according to various aqueous basic etching compositions in respect to their etching performances, represented as the etching efficiency obtained after etching a surface of a copper substrate using the respective aqueous basic etching compositions, are shown. Each bar (C1), (C2) and (E1) to (E7), as well as (C3), (C4) and (E8) to (E18) represents a different aqueous basic etching compositions.

In Table 3 a schematic correlation between various etched surfaces of respective copper substrates and the roughness of the respective etched surface, represented as the surface roughness S_{Q} obtained after etching a surface of a copper substrate using the respective aqueous basic etching composition of Table 1, is shown.

Further details are given in the "Examples" section below in the text.

### Detailed Description of the Invention

In the context of the present invention, the term "at least one" or "one or more" denotes (and is exchangeable with) "one, two, three or more than three".

The term Cₓ-C_{y} according to the present invention refers to a substance comprising a total number from X carbon atoms to Y carbon atoms. For example, the term C₁-C₆ alkyl refers to alkyl compounds comprising a total number from 1 carbon atom to 6 carbon atoms.

The present invention according to the first aspect provides an aqueous basic etching composition for the treatment of surfaces of metal substrates, the composition comprising:
(a) functionalized urea, biuret and guanidine derivatives and/or salts thereof selected from the group comprising compounds having formulae I and II and/or salts thereof: 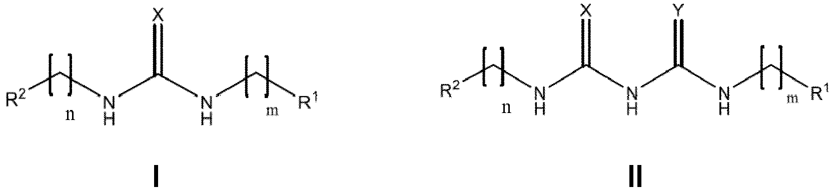 wherein
   X and Y are independently selected from the group comprising oxygen, NRR' and NR⁵,
   wherein R, R' and R⁵ are independently selected from the group comprising R¹, hydrogen, polyethylene glycoles, aromatic compounds, and C₁-C₄ alkyl,
   wherein the aromatic compounds and C₁-C₄ alkyl optionally comprise at least one substituent selected as OR⁶,
   wherein R⁶ is selected from the group comprising hydrogen and C₁-C₄ alkyl,
   wherein X and Y can be identical or different;
   R¹ and R² are independently selected from the group comprising hydrogen, alkyl compounds, amines, and nitrogen-comprising heteroaromatic compounds,
   wherein R¹ and R² can be identical or different, with the proviso that R¹ cannot be hydrogen;
   m is an integer from 1 to 4, preferably 3; and
   n is an integer from 0 to 8, preferably 2 to 4;
   wherein m and n can be identical or different, wherein n and m cannot be 0 at the same time;
(b) an oxidizing agent for oxidizing the metals of the metal surface to be treated; and
   wherein the aqueous basic etching composition comprises a pH from 7.1 to 14, preferably 8 to 12.

According to the first aspect substituents R¹ and R² are independently selected from the group comprising inter alia hydrogen, wherein substituents of the compounds of formula I or II can be identical or different, with the proviso that R¹ cannot be hydrogen. This means that while substituent R² can be selected as hydrogen substituent R¹ cannot be selected as hydrogen, thereby for example excluding that methyl urea, H₂N-CO-NH-CH₃, is covered by compounds of formula I.

According to the first aspect substituents R¹ and R² are independently selected from the group comprising inter alia alkyl compounds, wherein said alkyl compounds can be branched or unbranched, wherein said alkyl compounds are preferably either non-substituted or comprise an substituent, in particular an ether substituent.

According to the first aspect substituents R¹ and R² are independently selected from the group comprising inter alia amines, wherein said amines preferably comprise primary, secondary and/or tertiary amines, wherein said amines more preferably comprise alkyl-substituted amines, or amino-alkyl-substituted amines, or alkyl-substituted amines, wherein the alkyl group additionally comprises an additional functionalized urea substituent.

According to the first aspect substituents R¹ and R² are independently selected from the group comprising inter alia nitrogen-comprising heteroaromatic compounds, wherein said nitrogen-comprising heteroaromatic compounds are preferably 4- to 10-membered heteroaromatic compounds comprising from 1 to 4 nitrogen atoms.

One advantage, which is achieved by the aqueous basic etching composition according to the first aspect of the present invention, results in an efficient etching, in particular with constant etching rates in [µm/h], of a plurality of metal surfaces, in particular of silver, copper, nickel and/or cobalt surfaces. A constant etching efficiency, i.e. constant etching rate, results in an evenly etched metal surface.

Depending on the metal type and thickness of the substrate, the etching efficiency, which is correlated to the etching rate in [µm/h], can be adjusted by selecting the desired compound of formulae I and/or II, to allow for a higher or small etching efficiency.

By applying said aqueous basic etching composition according to the first aspect of the present invention an effective roughness of the treated metal surfaces can be achieved, which allows for an efficient adhesion of any additional layer deposited on the treated surface of the etched metal substrate, so that a desired opaque colour of the additional layer can be ensured.

In particular, the aqueous basic etching composition can be regenerated so that the material consumption is limited, and an cost-effective and environmentally friendly process can be ensured.

Moreover, due to the nitrogen functionalities present in the functionalized urea, biuret and guanidine derivatives having formulae I and II a highly efficient stabilization of metal ions in the composition can be achieved by chelatization of said metal ions, which results in a reduced precipitation tendency of said metal ions.

Preferably, the functionalized urea, biuret and guanidine derivatives and/or salts thereof are selected as compounds having formula I and/or salts thereof.

The etching composition is an aqueous basic etching composition, which preferably comprises more than 50 vol.-% water, based on the total volume of the aqueous basic etching composition, more preferably comprises 75 vol.-% or more water, even more preferably comprises 85 vol.-% or more water, even more preferably comprises 90 vol.-% or more water, even more preferably comprises 95 vol.-% or more water, and most preferably comprises 99 vol.-% or more water. Preferably, water is the only solvent in the aqueous basic etching composition.

According to the present invention, salts include, but are not limited to, alkaline metal salts such as sodium salt, potassium salt and the like; alkaline earth metals such as calcium salt, magnesium salt and the like; organic amine salts such as triethylamine salt, pyridine salt, picoline salt, ethanolamine salt, triethanolamine salt, dicyclohexylamine salt, and the like; inorganic acid salts such as halides, preferably chloride, bromide, fluoride and/or iodide, hydrochloride, hydrobromide, sulfate, phosphate and the like; organic acid salts such as formate, acetate, trifluoroacetate, maleate, tartrate and the like; sulfonates such as methanesulfonate, benzenesulfonate, p-toluenesulfonate, and the like; amino acid salts such as arginate, asparginate, glutamate and the like.

Preferably, salts include alkaline metal salts, such as sodium salt, potassium salt and the like; alkaline earth metals such as calcium salt, magnesium salt and the like; and/or inorganic acid salts such as halides, more preferably chloride, bromide, fluoride and/or iodide, sulfate, and the like.

Preferably, the oxidizing agent for oxidizing the metals of the metal surface to be treated comprises oxygen dissolved in the aqueous basic etching composition.

Preferably the oxygen dissolved in the aqueous basic etching composition originates from atmospheric oxygen diffusing from the ambient air into the aqueous basic etching composition.

By employing oxygen, in particular atmospheric oxygen which automatically diffuses from the ambient air into the aqueous basic etching composition, a sufficient concentration of oxidizing agent can be maintained in the composition for an extended period of time, which allows for an efficient oxidation of the metals of the metal surface to be treated without the necessity of manually adding additional oxidizer to the composition.

An aqueous basic etching composition of the present invention is preferred, wherein X is selected from the group comprising oxygen and NR⁵,
wherein R⁵ is selected from the group comprising R¹, hydrogen, polyethylene glycoles, aromatic compounds, and C₁-C₄ alkyl, wherein the aromatic compounds and C₁-C₄ alkyl optionally comprise at least one substituent selected as OR⁶, wherein R⁶ is selected from the group comprising hydrogen and C₁-C₄ alkyl;
wherein preferably R⁵ is selected from the group comprising hydrogen and C₁-C₄ alkyl,
wherein more preferably R⁵ is selected from the group comprising hydrogen and C₁-C₃ alkyl,
wherein even more preferably R⁵ is selected from the group comprising hydrogen and C₁- or C₂ alkyl, and
wherein most preferably R⁵ is selected from the group comprising hydrogen and methyl.

An aqueous basic etching composition of the present invention is preferred, wherein X is selected from the group comprising oxygen and NH, and wherein X preferably is oxygen.

An aqueous basic etching composition of the present invention is preferred, wherein the functionalized urea, biuret and guanidine derivatives and/or salts thereof are selected as compounds having formula II and/or salts thereof, wherein Y is selected from the group comprising oxygen and NRR",
wherein R and R" are independently selected from the group comprising R¹, hydrogen, polyethylene glycoles, aromatic compounds, and C₁-C₄ alkyl, wherein the aromatic compounds and C₁-C₄ alkyl optionally comprise at least one substituent selected as OR⁶, wherein R⁶ is selected from the group comprising hydrogen and C₁-C₃ alkyl,
wherein preferably R and R" are independently selected from the group comprising hydrogen and C₁-C₄ alkyl,
wherein more preferably R and R" are independently selected from the group comprising hydrogen and C₁-C₃ alkyl,
wherein even more preferably R and R" are independently selected from the group comprising hydrogen and C₁- or C₂ alkyl, and
wherein most preferably R and R" are independently selected from the group comprising hydrogen and methyl.

An aqueous basic etching composition of the present invention is preferred, wherein the functionalized urea, biuret and guanidine derivatives and/or salts thereof are selected as compounds having formula II and/or salts thereof, wherein Y is selected from the group comprising oxygen and NH, and wherein preferably Y is oxygen.

An aqueous basic etching composition of the present invention is preferred, wherein R² is selected as hydrogen.

An aqueous basic etching composition of the present invention is preferred, wherein at least one of R¹ and R² is selected as alkyl compounds, which can be branched or unbranched, preferably as C₁-C₆ alkyl, more preferably as C₁-C₄ alkyl, even more preferably as C₂- or C₃ alkyl, and most preferably as isopropyl or isopentyl.

Preferably, when parameter n is selected as 0, substituent R² is selected as C₁-C₆ alkyl, comprising one substituent selected as -O-(C₁-C₆ alkyl)-NH-CO-NH-(Ci-C₆ alkyl)-NR⁷R⁸, wherein R⁷ and R⁸ are independently selected from hydrogen and C₁-C₆ alkyl.

More preferably, when parameter n is selected as 0, substituent R² is selected as C₁-C₃ alkyl, comprising one substituent selected as -O-(C₁-C₃ alkyl)-NH-CO-NH-(C₁-C₃ alkyl)-NR⁷R⁸, wherein R⁷ and R⁸ are independently selected from C₁-C₃ alkyl.

Even more preferably, when parameter n is selected as 0, substituent R² is selected as isopropyl, comprising one substituent selected as -O-(C₃ alkyl)-NH-CO-NH-(C₃ alkyl)-NR⁷R⁸, wherein R⁷ and R⁸ are both selected from C₁-C₃ alkyl.

An aqueous basic etching composition of the present invention is preferred, wherein both of R¹ and R² is selected as alkyl compounds, which can be branched or unbranched, preferably as C₁-C₆ alkyl, more preferably as C₁-C₄ alkyl, even more preferably as C₂- or C₃ alkyl, and most preferably as isopropyl or isopentyl.

An aqueous basic etching composition of the present invention is preferred, wherein at least one of R¹ and R² is selected from the group comprising NH₂, NHR³ and NR³R⁴,
wherein R³ and R⁴ are independently selected from the group comprising C₁-C₁₆ alkyl, 5- to 16-membered aryl and 5- to 16-membered heteroaryl, optionally comprising at least one substituent selected from the group comprising OR⁶, wherein R⁶ is selected from the group comprising hydrogen and C₁-C₆ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein preferably R³ and R⁴ are independently selected from C₁-C₁₀ alkyl, 5- to 10-membered aryl and 5- to 10-membered heteroaryl, optionally comprising at least one substituent selected from the group comprising OR⁶, wherein R⁶ is selected from the group comprising hydrogen and C₁-C₆ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein more preferably R³ and R⁴ are independently selected from the group comprising C₁-C₆ alkyl, 5- to 6-membered aryl and 5- to 6-membered heteroaryl, optionally comprising at least one substituent selected from the group comprising OR⁶, wherein R⁶ is selected from the group comprising hydrogen and C₁-C₃ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein even more preferably R³ and R⁴ are independently selected from the group comprising C₁-C₃ alkyl, phenyl, imidazole and pyridine, optionally comprising at least one substituent selected from the group comprising OR⁶, wherein R⁶ is selected from the group comprising hydrogen and C₁-C₃ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein most preferably R³ and R⁴ are independently selected as C₁-C₃ alkyl, and
wherein even most preferably R³ and R⁴ are independently selected as methyl.

An aqueous basic etching composition of the present invention is preferred, wherein both of R¹ and R² are selected from the group comprising NH₂, NHR³ and NR³R⁴,
wherein R³ and R⁴ are independently selected from the group comprising C₁-C₁₆ alkyl, 5- to 16-membered aryl and 5- to 16-membered heteroaryl, optionally comprising at least one substituent selected from the group comprising OR⁶, wherein R⁶ is selected from the group comprising hydrogen and C₁-C₆ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein preferably R³ and R⁴ are independently selected from the group comprising C₁-C₁₀ alkyl, 5- to 10-membered aryl and 5- to 10-membered heteroaryl, optionally comprising at least one substituent selected from the group comprising OR⁶, wherein R⁶ is selected from the group comprising hydrogen and C₁-C₆ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein more preferably R³ and R⁴ are independently selected from the group comprising C₁-C₆ alkyl, 5- to 6-membered aryl and 5- to 6-membered heteroaryl, optionally comprising at least one substituent selected from the group comprising OR⁶, wherein R⁶ is selected from the group comprising hydrogen and C₁-C₃ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein even more preferably R³ and R⁴ are independently selected from C₁-C₃ alkyl, phenyl, imidazole and pyridine, optionally comprising at least one substituent selected from the group comprising OR⁶, wherein R⁶ is selected from the group comprising hydrogen and C₁-C₃ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein most preferably R³ and R⁴ are independently selected as C₁-C₃ alkyl, and
wherein even most preferably R³ and R⁴ are independently selected as methyl.

An aqueous basic etching composition of the present invention is preferred, wherein at least one of R¹ and R² is selected as nitrogen-comprising heteroaromatic compounds,
wherein preferably at least one of R¹ and R² is selected as 4- to 10-membered heteroaromatic compounds comprising from 1 to 4 nitrogen atoms, optionally comprising at least one substituent selected from the group comprising OR⁶ and C₁-C₄ alkyl, wherein R⁶ is selected from the group comprising hydrogen and C₁-C₃ alkyl;
wherein more preferably at least one of R¹ and R² is selected as 4- to 8-membered heteroaromatic compounds comprising from 1 to 3 nitrogen atoms, optionally comprising at least one substituent selected from the group comprising OR⁶ and C₁-C₃ alkyl, wherein R⁶ is selected from the group comprising hydrogen and C₁- or C₂ alkyl;
wherein even more preferably at least one of R¹ and R² is selected as 5-to 6-membered heteroaromatic compounds comprising from 1 to 2 nitrogen atoms, optionally comprising at least one substituent selected from the group comprising OR⁶ and C₁-C₆ alkyl, wherein R⁶ is selected from the group comprising hydrogen and C₁-C₆ alkyl;
wherein most preferably at least one of R¹ and R² is selected from the group comprising imidazole and pyridine, optionally comprising at least one substituent selected as C₁-C₆ alkyl; and
wherein even most preferably at least one of R¹ and R² is selected from the group comprising imidazole and pyridine, optionally comprising at least one substituent selected as C₁-C₃ alkyl.

The pyridine selection for at least one of substituents R¹ and R² can comprise a 2-pyridyl, 3-pyridyl or 4-pyridyl substitution.

An aqueous basic etching composition of the present invention is preferred, wherein both R¹ and R² are selected as nitrogen-comprising heteroaromatic compounds,
wherein preferably both R¹ and R² are selected as 4- to 10-membered heteroaromatic compounds comprising from 1 to 4 nitrogen atoms, optionally comprising at least one substituent selected from the group comprising OR⁶ and C₁-C₄ alkyl, wherein R⁶ is selected from the group comprising hydrogen and C₁-C₃ alkyl;
wherein more preferably both R¹ and R² are selected as 4- to 8-membered heteroaromatic compounds comprising from 1 to 3 nitrogen atoms, optionally comprising at least one substituent selected from the group comprising OR⁶ and C₁-C₃ alkyl, wherein R⁶ is selected from the group comprising hydrogen and C₁-C₁- or C₂ alkyl;
wherein even more preferably both R¹ and R² are selected as 5- to 6-membered heteroaromatic compounds comprising from 1 to 2 nitrogen atoms, optionally comprising at least one substituent selected from the group comprising OR⁶ and C₁-C₆ alkyl, wherein R⁶ is selected from the group comprising hydrogen and C₁-C₆ alkyl;
wherein most preferably both R¹ and R² are selected from the group comprising imidazole and pyridine, optionally comprising at least one substituent selected as C₁-C₆ alkyl; and
wherein even most preferably both R¹ and R² are selected from the group comprising imidazole and pyridine, optionally comprising at least one substituent selected as C₁-C₃ alkyl.

The pyridine selection for at least one of substituents R¹ and R² can comprise a 2-pyridyl, 3-pyridyl or 4-pyridyl substitution.

An aqueous basic etching composition of the present invention is preferred, wherein n is an integer from 0 to 4, preferably 0, 1 or 3.

An aqueous basic etching composition of the present invention is preferred, wherein the functionalized urea, biuret and guanidine derivatives and/or salts thereof are selected as compounds having formula I and/or salts thereof, wherein X is selected from the group comprising oxygen and NH, wherein m is 3, wherein n is 0 or 3,
wherein R¹ is selected from the group comprising:
(a) NH₂, NHR³ and NR³R⁴, wherein R³ and R⁴ are independently selected as C₁-C₆ alkyl, preferably C₁-C₃ alkyl, more preferably methyl, optionally comprising one of the substituents selected from the group comprising NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
(b) 4- to 10-membered heteroaromatic compounds, preferably 5- to 6-membered heteroaromatic compounds, more preferably imidazole or pyridine, optionally comprising at least one substituent selected as C₁-C₆ alkyl; and
(c) C₁-C₆ alkyl, which can be branched or unbranched, preferably C₁-C₄ alkyl, more preferably C₂ or C₃ alkyl, and most preferably isopropyl or isopentyl;
   and wherein R² is selected from the group comprising:
   (a) hydrogen;
   (b) NH₂, NHR³ and NR³R⁴, wherein R³ and R⁴ are independently selected as C₁-C₆ alkyl, preferably C₁-C₃ alkyl, more preferably methyl, optionally comprising one of the substituents selected from the group comprising NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
   (c) 4- to 10-membered heteroaromatic compounds, preferably 5- to 6-membered heteroaromatic compounds, more preferably imidazole or pyridine, optionally comprising at least one substituent selected as C₁-C₆ alkyl; and
   (d) C₁-C₆ alkyl, which can be branched or unbranched, preferably C₁-C₄ alkyl, more preferably C₂ or C₃ alkyl, and most preferably isopropyl or isopentyl.

An aqueous basic etching composition of the present invention is preferred, wherein the functionalized urea, biuret and guanidine derivatives and/or salts thereof are selected as compounds having formula I and/or salts thereof, wherein
(a) X is selected as oxygen, m and n are both selected as 3, and R¹ and R² are both selected as N(methyl)₂, 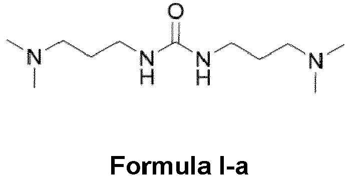
(b) X is selected as oxygen, m and n are both selected as 3, and R¹ and R² are both selected as imidazole, 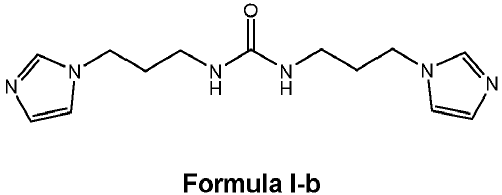
(c) X is selected as oxygen, m and n are both selected as 1, and R¹ and R² are both selected as pyridine, wherein preferably R¹ and R² are both selected as (c-1) 2-pyridyl, (c-2) 3-pyridyl, or (c-3) 4-pyridyl, 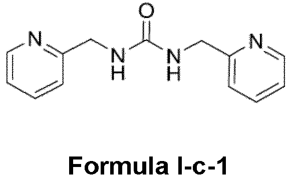 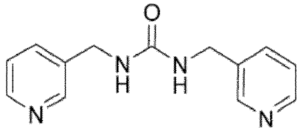 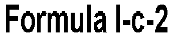 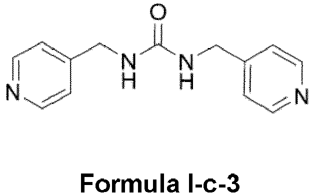
(d) X is selected as oxygen, m is selected as 3, n is selected as 0, R¹ is selected as N(methyl)₂ and R² is selected as hydrogen, 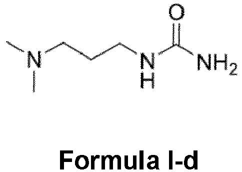
(e) X is selected as NH, m and n are both selected as 3, and R¹ and R² are both selected as N(methyl)₂, 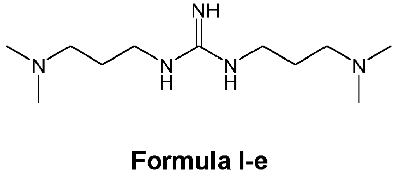
(f) X is selected as oxygen, m and n are both selected as 2, and R¹ and R² are both selected as N(methyl)₂, 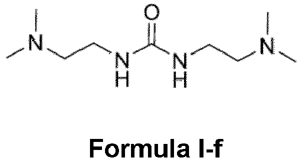
(g) X is selected as oxygen, m is selected as 2, n is selected as 0, R¹ is selected as N(methyl)₂ and R² is selected as hydrogen, 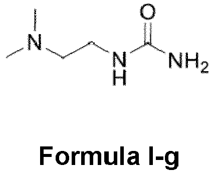
(h) X is selected as oxygen, m and n are both selected as 3, R² is selected as N(methyl)₂, and R¹ is selected as -N(methyl)-(CH₂)₃-NH-CO-NH-(CH₂)₃-N(methyl)₂, 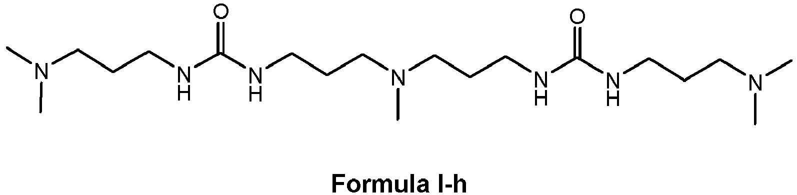
(i) X is selected as oxygen, m and n are both selected as 3, R² is selected as N(methyl)₂, and R¹ is selected as -N(methyl)-(CH₂)₃-NH₂, and/or 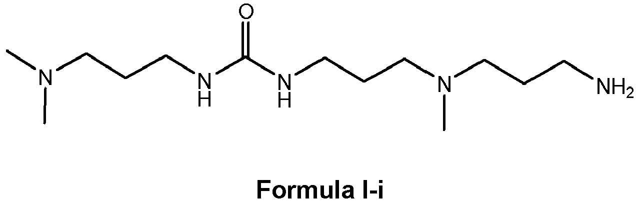
(j) X is selected as oxygen, n is selected as 0, m is selected as 3, j is selected as 7, R¹ is selected as N(methyl)₂, and R² is selected as-CH(CH₃)-(CH₂)-O-(CH₂)-CH(CH₃)-NH-CO-NH-(CH₂)₃-N(methyl)₂.

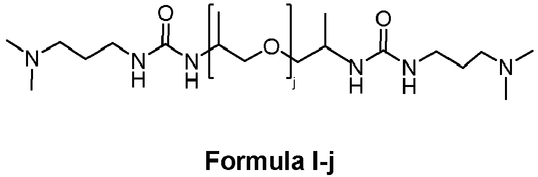

An aqueous basic etching composition of the present invention is preferred, wherein the functionalized urea, biuret and guanidine derivatives and/or salts thereof are selected as compounds having formula II and/or salts thereof, wherein
(a) X and Y are selected as oxygen, m and n are both selected as 3, R¹, R² are both selected as N(methyl)₂.

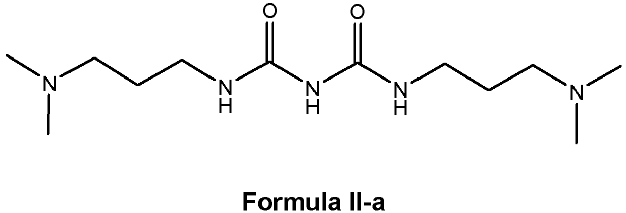

An aqueous basic etching composition of the present invention is preferred, wherein the oxidizing agent for oxidizing the metals of the metal surface to be treated comprises oxygen dissolved in the aqueous basic etching composition, wherein the oxygen dissolved in the aqueous basic etching composition preferably originates from atmospheric oxygen diffusing from the ambient air into the aqueous basic etching composition.

By allowing oxygen, in particular atmospheric oxygen, as an oxidizing agent for oxidizing the metals a highly efficient and automatic etching reaction can be facilitated without the necessity to manually adding additional oxidizer.

An aqueous basic etching composition of the present invention is preferred, wherein the composition does not comprise any additional oxidizing agent besides the one oxidizing agent being oxygen dissolved in the aqueous basic etching composition, wherein preferably the composition does not comprise any peroxide and/or persulfate compound.

By omitting the addition of any additional oxidizer from the aqueous basic etching composition the material consumption can be reduced and also an excessive etching of the metal surface can be prevented.

An aqueous basic etching composition of the present invention is preferred, wherein the composition comprises an additional oxidizing agent for oxidizing the metals of the metal surface to be treated, wherein preferably the additional oxidizing agent is selected as a peroxide and/or persulfate compound.

By adding the additional oxidizing agent in addition to the oxidizing agent already present in the composition, the etching rate can be efficiently increased.

An aqueous basic etching composition of the present invention is preferred, wherein the aqueous basic etching composition comprises a pH from 7.1 to 14, preferably from 8 to 12, more preferably from 9 to 11, and most preferably the pH is 10.

By selecting the pH in the preferred ranges an efficient etching process can be ensured.

An aqueous basic etching composition of the present invention is preferred, wherein the compounds having formulae I and II and/or salts thereof are present in the composition at a total concentration from 1 wt.-% to 15 wt.-% based on the total weight of the composition, preferably at a total concentration from 2 wt.-% to 14 wt.-%, more preferably from 3 wt.-% to 13 wt.-%, even more preferably from 4 wt.-% to 13 wt.-%, and most preferably from 5 wt.-% to 12.5 wt.-%.

By selecting the concentration of the compounds having formulae I and II in the preferred concentration ranges an efficient etching process can be ensured.

An aqueous basic etching composition of the present invention is preferred, wherein the metal substrates to be treated comprise all metals and metal alloys which are less noble than gold, preferably with the exception of iron, chromium and nickel-chromium steel alloys.

An aqueous basic etching composition of the present invention is preferred, wherein the metal substrates to be treated comprise metals or metal alloys selected from the group comprising silver, palladium, copper, nickel, cobalt, manganese, zinc, lead, antimony, tin, rare earth metals, for example neodymium, copper-zinc alloy, cupper-tin alloy, copper-nickel alloy, and aluminum-magnesium alloy.

An aqueous basic etching composition of the present invention is preferred, wherein the metal substrates to be treated comprise silver, copper, nickel and cobalt.

Thereby, the etching properties of the aqueous basic etching composition are adjusted to allow for an efficient etching of a huge variety of metal substrates.

An aqueous basic etching composition of the present invention is preferred, wherein the composition further comprises:
(iii) an anionic agent, which is selected as an acid or a metal salt of an acid, wherein preferably the acid is selected from the group comprising hydrochloric acid, sulfuric acid, bromic acid, carboxylic acids, more preferably acetic acid, alkyl sulfonic acid, more preferably methane sulfonic acid, aryl sulfonic acid, preferably tosylate compounds, and metal salts thereof.

An aqueous basic etching composition of the present invention is preferred, wherein the composition comprises the anionic agent at a total concentration in a range from 1 wt.-% to 30 wt.-% based on the total weight of the composition, preferably in a range from 2 wt.-% to 25 wt.-%, more preferably in a range from 3 wt.-% to 20 wt.-%, even more preferably in a range from 5 wt.-% to 15 wt.-%, and most preferably at 10 wt.-%.

Thereby, the etching properties of the aqueous basic etching composition can be efficiently improved by adding the preferred anionic agent, preferably at the preferred concentrations.

According to a second aspect the present invention is further directed to a method for treating a surface of a metal substrate, the method comprising the steps:
(A) providing said metal substrate,
(B) providing an aqueous basic etching composition for the treatment of surfaces of metal substrates according to the first aspect, and
(C) contacting the metal substrate with said aqueous basic etching composition such that the surface of the metal substrate is etched.

The method according to the second aspect ensures an efficient etching process.

A method of the present invention is preferred, wherein the method is performed at a temperature from 20 °C to 100 °C, preferably from 30 °C to 80 °C, more preferably from 40 °C to 60 °C, most preferably at 50 °C.

By performing the method at the preferred temperature ranges, a highly efficient etching reaction can be ensured.

A method of the present invention is preferred, wherein the metal substrates to be treated comprise all metals and metal alloys which are less noble than gold, preferably with the exception of iron, chromium and nickel-chromium steel alloys.

A method of the present invention is preferred, wherein the metal substrates to be treated comprise metals or metal alloys selected from the group comprising silver, palladium, copper, nickel, cobalt, manganese, zinc, lead, antimony, tin, rare earth metals, for example neodymium, copper-zinc alloy, copper-tin alloy, copper-nickel alloy, and aluminum-magnesium alloy.

A method of the present invention is preferred, wherein the metal substrates to be treated comprise silver, copper, nickel and/or cobalt.

Thereby, the etching efficiency of the method is adjusted to allow for an efficient etching of a huge variety of metal substrates.

A method of the present invention is preferred, wherein during method step (C) a voltage is applied to the metal substrate.

A method of the present invention is preferred, wherein the method comprises the further step:
(D) recycling the aqueous basic etching composition after method step (C), wherein step (D) comprises the steps:
(D1) Increasing the temperature of the aqueous basic etching composition to obtain a temperature-increased aqueous basic etching composition,
(D2) Filtering the temperature-increased aqueous basic etching composition to obtain a filtered aqueous basic etching composition; and
(D3) Reapplying the filtered aqueous basic etching composition to method step (C).

Thereby, the recycling step of the method allows for an efficient recovery of metals from the aqueous basic etching composition. By heating the aqueous basic etching composition, metals are precipitated from the aqueous basic etching composition, in particular due to the impairment of the chemical stabilization of the metals by the compounds of formula I or II caused by the temperature increase. The resulting precipitate can be removed from the solution by filtration and can be externally processed to recover the metals.

A method of the present invention is preferred, wherein method step (D1) comprises increasing the temperature of the aqueous basic etching composition above a temperature of 50 °C, preferably above a temperature of 60 °C, more preferably above a temperature of 70°C, and most preferably above a temperature of 80 °C to obtain a temperature-increased aqueous basic etching composition.

By increasing the temperature of the aqueous basic etching composition above the preferred temperatures the compounds of formula I or II do not stabilize the respective metal ions anymore, resulting in a precipitation of corresponding metal salts.

A method of the present invention is preferred, wherein precipitates formed in the aqueous basic etching composition during method step (D1) are removed from the aqueous basic etching composition during method step (D2) to obtain a precipitate-reduced filtered aqueous basic etching composition after method step (D2).

By removing the precipitates from the aqueous basic etching composition the metal ions, which have been removed from the treated metal surface, can be efficiently recovered.

A method of the present invention is preferred, wherein during method step (C) the metal is removed from the surface of the metal substrate with a constant etching rate, preferably from 0.01 µm/h to 10 µm/h, more preferably from 0.05 µm/h to 5 µm/h, and even more preferably from 0.1 µm/h to 2.5 µm/h.

A constant etching process, preferably at the preferred etching rates, allows for a particular even surface of the treated metal, thereby ensuring superior surface qualities of such treated metal surfaces.

A method of the present invention is preferred, wherein the metal substrate provided during step (A) comprises a opaque or rough surface.

A opaque and/or rough surface ensures superior qualities of the treated metal surface, in particular when depositing an additional layer on the treated metal surface.

A method of the present invention is preferred, wherein the metal substrate provided during step (A) is formed as a flexible metal substrate, preferably as a flexible copper substrate, more preferably as a flexible copper-coated polymer.

A method of the present invention is preferred, wherein the metal substrate provided during step (A) is formed as a copper-coated laminate, or a uniform copper substrate.

By etching different kind of metal substrates with different chemical and physical properties the method can be applied in a wide scope of applications and is therefore generally usable.

For example, for printed circuit boards (PCBs) a copper-coated resin, in particular polymer, can be used or a copper-coated glass can be used as metal substrates. Alternatively, for general manufacturing goods, copper-coated plastics oder copper-coated sheet metal can be used as metal substrates.

A method of the present invention is preferred, wherein step (B) and/or (C) is performed under stirring, preferably at a stirring rate from 20 rpm to 1.000 rpm, more preferably from 50 rpm to 500 rpm, and most preferably at 100 rpm.

A method of the present invention is preferred, wherein step (C) is performed for a duration less than 2 hours, preferably less than 1 hour, more preferably less than 45 min, even more preferably less than 30 min, and most preferably less than 15 min.

A method of the present invention is preferred, wherein step (C) is performed for a duration from 1 min to 2 hours, preferably from 5 min to 1.5 hours, more preferably from 15 min to 1 hour and most preferably from 30 min to 45 min.

The preferred stirring and time intervals of the method allow for an efficient etching rate, which can be individually adjusted according to the used metal substrate.

A method of the present invention is preferred, wherein the method comprises a step (P), which is performed prior to step (C), wherein step (P) comprises:
(P1) pre-rinsing the metal substrate with an acidic solution, preferably comprising sulfuric acid to obtain a pre-rinsed metal substrate,
(P2) washing the pre-rinsed metal substrate with a wash solution, preferably comprising desalted water, to obtain a washed metal substrate, and
   wherein the washed metal substrate is contacted with said aqueous basic etching composition during step (C).

By pre-rinsing the metal substrate with the acidic solution and a subsequent washing step, an efficient cleaning of the metal surface to be treated during step (C) can be ensured, thereby increasing the effectivity of the method. By pre-rinsing the substrate any potential corrosion of the substrate and/or surface contaminations of the substrate can be efficiently removed before transferring the substrate into the aqueous basic etching composition.

However, method step (P) is an optional method step, and the method according to the second aspect the present invention can be also performed without method step (P).

Preferably, the aforementioned regarding the aqueous basic etching composition according to the first aspect of the present invention, preferably what is described as being preferred, applies likewise to the method according to the second aspect of the present invention.

According to a third aspect the present invention is further directed to a metal substrate with an etched surface, wherein the etched surface of the metal substrate has been obtained by a method for treating a surface of a metal substrate according to the second aspect.

A substrate of the present invention is preferred, wherein the metal substrate comprises an etched surface, wherein the etched surface comprises a roughness S_{Q} from 320 to 1400.

A roughness S_{Q} in the preferred range from 320 to 1400 allows for an efficiently etched surface, which enables a highly advantageous deposition of additional layers on the etched surface.

The roughness S_{Q} of the etched surface of the metal substrate in particular has been measured in analogy to ISO 25178, which allows for a determination of the roughness of surfaces. The roughness S_{Q} of the etched surface of the metal substrate in particular has been measured based on 3D-represenations of the etched surface, which for example are obtained by interference microscopy of substrate samples. However, no filter has been applied to the raw data, since the required would be dependent on the surface property of the corresponding etched surface.

Preferably, the aforementioned regarding the aqueous basic etching composition according to the first aspect of the present invention and the method according to the second aspect of the present invention, preferably what is described as being preferred, applies likewise to the substrate according to the third aspect of the present invention.

### EXAMPLES

### First series of experiments

For a first series of experiments, respective test aqueous etching compositions E1 to E8 were prepared (weight: appr. 10 g) comprising 5 wt.-% of the respective functionalized urea, biuret or guanidine derivatives as summarized below. The pH was in a range from 9.0 to 12.6.

In each test, a piece of copper foil (1 cm x 4 cm) comprising a chromium surface at one side, and which has not been pre-rinsed and pre-washed, is immersed into the respective aqueous etching composition, contained in a test tube. The test tube was provided with an atmosphere of ambient air and was sealed by a rubber plug for a duration of 336 hours at a temperature of 22 °C to allow for a reaction to occur. In the test tube a small, Teflon-coated stirring bar was rotated at 100 rpm.

The etching efficiency (EE) of the respective aqueous etching composition was determined based on the reduction of thickness of the non-chromium comprising surface of the copper foil after reaction.

Control experiments C1 and C2 were performed, wherein in control experiment C1 no functionalized urea, biuret or guanidine derivative was added to the respective composition, and wherein in control experiment C2 the pH was reduced to a pH of less than 7 by adding sulfuric acid to the respective composition.

The results shown in Table 1 for etching efficiency are qualitatively ranked having the following synonyms:
- +++: Excellent
- ++: Good
- +: Medium
- -: Bad

**Table 1: Etching efficiencies of various functionalized urea, biuret and guanidine derivatives**

| **Exp.** | **Functionalized urea, biuret or guanidine derivative** | **pH** | **EE** |
|---|---|---|---|
| C1 | none | 11.1 | - |
| C2 | 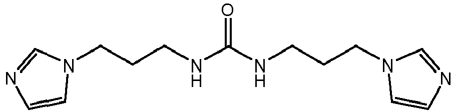 | < 7 | - |
| E1 | 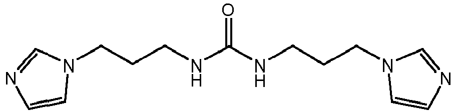 | 11.1 | +++ |
| E2 | 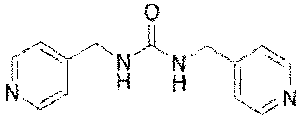 | 9.00 | ++ |
| E3 | 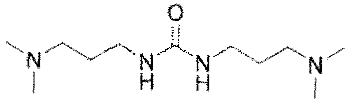 | 11.8 | + |
| E4 | 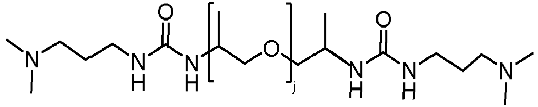 | 11.7 | + |
| | wherein j is 7 | | |
| E5 | 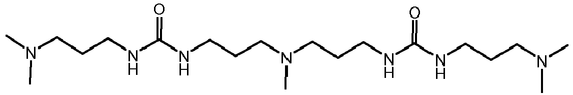 | 11.7 | ++ |
| E6 | 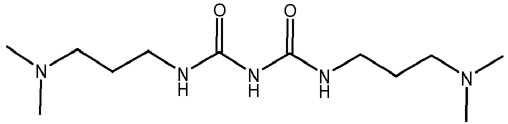 | 11.5 | + |
| E7 | 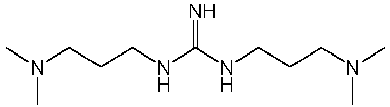 | 12.6 | ++ |

When comparing control experiment C1, wherein no functionalized urea, biuret or guanidine derivative has been added, with experiments E1 to E7, wherein a functionalized urea, biuret or guanidine derivative has been added, it can be observed that the addition of a functionalized urea, biuret or guanidine derivative is critical to observe at least a medium, but in most cases good or even excellent, etching efficiency in respect to the copper foil.

Moreover, when comparing control experiment C2, wherein the pH of the composition was below 7, with experiments E1 to E7, wherein the pH of the respective composition is in a range between 9.0 and 12.6, it can be observed that a basic pH of the respective composition is also critical to observe at least a medium, but in most cases good or even excellent, etching efficiency in respect to the copper foil.

However, when comparing the etching efficiency of experiments E1 to E7 differences can be observed.

When using a functionalized urea derivative with terminal heteroaromatic substituents, such as imidazole (see experiment E1) and pyridine (see experiment E2), an at least good or even excellent etching efficiency in respect to the copper foil is observed.

A functionalized urea derivative with terminal amine substituents still provides a good etching efficiency (see experiment E3 and E4), which is however surpassed by the corresponding functionalized guanidine derivative with terminal amine substituents (see experiment E7), wherein an excellent etching efficiency in respect to the copper foil is observed.

When using a functionalized urea derivative or a functionalized biuret derivative with at least one terminal alkyl substituent (see experiments E5 and E6), a medium etching efficiency in respect to the copper foil is observed.

### Second series of experiments

For a second series of experiments, respective test aqueous etching compositions E8 to E18 were prepared (weight: appr. 20 g) comprising 2.5 wt.-% of the respective functionalized urea, biuret or guanidine derivative as summarized below, resulting in 0.5 g of the respective functionalized urea, biuret or guanidine derivative in 19.5 g water. The pH was in a range from 8 to 13.

In each test, a piece of a copper metal sheet (weight: appr. 1 g), which has been pre-rinsed in an aqueous solution of 10 wt.-% of ammonium persulfate (APS) for a duration of 30 seconds at a temperature of 40 °C, and which has been pre-washed afterwards, is immersed into the respective aqueous etching composition. The composition was provided with an atmosphere of ambient air and was stirred at 100 U/min for a duration of 2 weeks at a temperature of 45 °C to allow for a reaction to occur.

Control experiments C3 and C4 were performed, wherein in control experiment C3 no functionalized urea, biuret or guanidine derivative was added to the respective composition, and wherein in control experiment C4 the pH was reduced to a pH of less than 7 by adding sulfuric acid to the respective composition.

The etching efficiency (EE) of the respective aqueous etching composition was determined based on the reduction of thickness of the copper surface of the copper foil after reaction.

The results shown in Table 2 for etching efficiency (EE) are qualitatively ranked having the following synonyms:
- +++: Excellent
- ++: Good
- +: Medium
- -: Bad

**Table 2: Etching efficiencies of various functionalized urea, biuret and guanidine derivatives**

| **Exp.** | **Functionalized urea, biuret and guanidine derivative** | **pH** | **EE** |
|---|---|---|---|
| C3 | none | 11.8 | - |
| C4 | 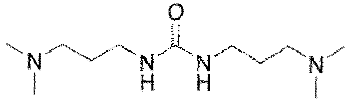 | <7 | - |
| E8 | 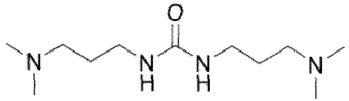 | 11.8 | ++ |
| E9 | 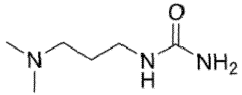 | 10.0 | + |
| E10 | 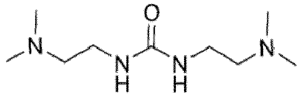 | 10.4 | ++ |
| E11 | 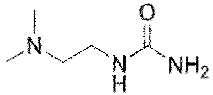 | 9.8 | + |
| E12 | 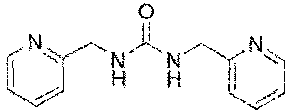 | 9.1 | ++ |
| E13 | 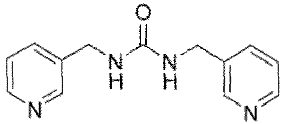 | 8.5 | + |
| E14 | 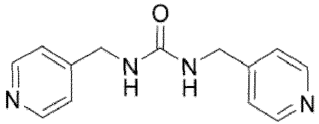 | 9.0 | ++ |
| E15 | 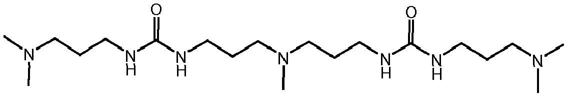 | 11.7 | ++ |
| E16 | 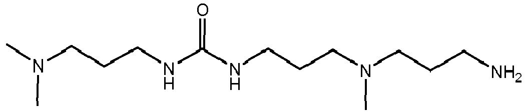 | 9.0 | + |
| E17 | 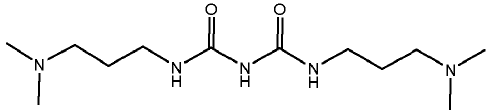 | 8.7 | + |
| E18 | 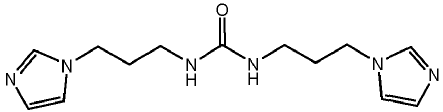 | 11.1 | +++ |

From experiments E15, E16 and E17 it can be derived that a functionalized urea or biuret derivative with a terminal alkyl substituent results in an observable, but medium, etching efficiency of the respective copper sheet.

Similar results can be observed when using a functionalized urea derivative with a terminal amino group (see experiments E9 and E11), wherein also an observable, but medium, respectively good, etching efficiency of the respective copper foil can be observed.

In experiments E12, E13 and E14 various functionalized urea derivatives with terminal heteroaromatic substituents, in particular pyridine, have been analyzed, which exhibit a medium, respectively good etching efficiency.

An excellent etching efficiency could be observed when analyzing a functionalized urea derivative with a terminal heteroaromatic substituents, in particular imidazole, as shown in experiment E18.

When comparing the functionalized urea derivatives with terminal amine substituents shown in Experiments E8 (wherein a C₃-linker between the urea and the terminal amine moiety is present) and E10 (wherein a C₂-linker between the urea and the terminal amine moiety is present), it appears that both the C₃-linker and the C₂-linker provide a good etching efficiency.

### Additional set of experiments

To investigate surface roughness of etched metal surfaces, pieces of etched copper foil have been analyzed by topographic imaging.

The respective pieces of etched copper foil have been obtained by applying a respective aqueous basic etching composition comprising a functionalized urea, biuret or guanidine derivative at a basic pH according to the second series of experiments (see above).

The roughness of the etched surface of the respective copper foil has been measured in analogy to ISO 25178, which allows for a determination of the roughness of surfaces. The roughness of the etched surface of the metal substrate in particular has been measured based on 3D-represenations of the etched surface, which for example are obtained by interference microscopy of substrate samples. However, no filter has been applied to the raw data, since the required would be dependent on the surface property of the corresponding etched surface.

In particular the root mean square roughness S_{Q} in analogy to ISO 25178 has been determined in respect to five measuring windows of a size of 249,6 µm x 249,6 µm of the respective etched copper piece, and the average value of S_{Q} [nm] has been determined, as shown in Table 3.

**Table 3: Average surface roughness S_{Q} of etched copper surfaces**

| **Exp.** | **Functionalized urea, biuret or guanidine derivative** | **pH** | **S_{Q} [nm]** |
|---|---|---|---|
| S1 | 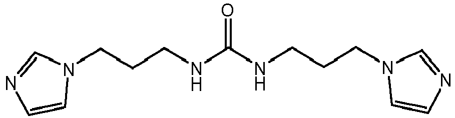 | 11.1 | 1263 |
| S2 | 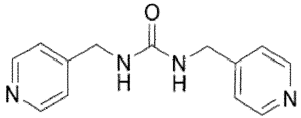 | 9.00 | 599 |
| S3 | 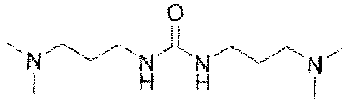 | 11.7 | 436 |
| S4 | 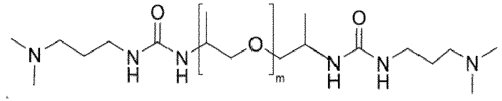 | 11.7 | 380 |
| S5 | 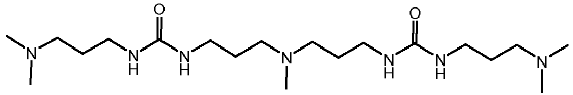 | 11.7 | 367 |
| S6 | 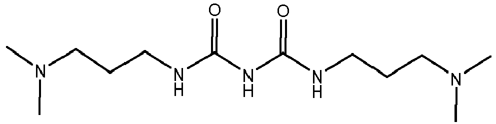 | 11.5 | 383 |
| S7 | | 12.6 | 427 |

When using using functionalized urea derivatives with terminal alkyl substituents a moderate surface roughness (see 367 nm for experiment S5, see 383 nm for experiment S5) can be observed.

As can be derived from experiments S1, S2, S3 and S7 the highest surfaces roughness (1263 nm for experiment S1, 599 nm for experiment S2, 436 nm for experiment S3, and 427 nm for experiment S7) was observed when using functionalized urea or guanidine derivatives with terminal heteroaromatic or terminal amine groups.

## Claims

1. An aqueous basic etching composition for the treatment of surfaces of metal substrates, the composition comprising:
(a) functionalized urea, biuret and guanidine derivatives and/or salts thereof selected from the group comprising compounds having formulae I and II and/or salts thereof: 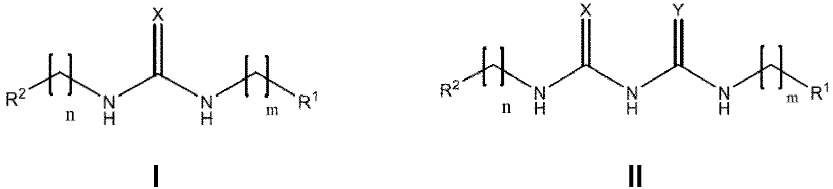 wherein
X and Y are independently selected from the group comprising oxygen, NRR' and NR⁵,
wherein R, R' and R⁵ are independently selected from the group comprising R¹, hydrogen, polyethylene glycoles, aromatic compounds, and C₁-C₄ alkyl, wherein the aromatic compounds and C₁-C₄ alkyl optionally comprise at least one substituent selected as OR⁶,
wherein R⁶ is selected from the group comprising hydrogen and C₁-C₄ alkyl, wherein X and Y can be identical or different;
R¹ and R² are independently selected from the group comprising hydrogen, alkyl compounds, amines, and nitrogen-comprising heteroaromatic compounds,
wherein R¹ and R² can be identical or different, with the proviso that R¹ cannot be hydrogen;
m is an integer from 1 to 4, preferably 3; and
n is an integer from 0 to 8, preferably 2 to 4;
wherein m and n can be identical or different;
(b) an oxidizing agent for oxidizing the metals of the metal surface to be treated; and
wherein the aqueous basic etching composition comprises a pH from 7.1 to 14.

2. An aqueous basic etching composition according to claim 1, wherein X is selected from the group comprising oxygen and NR⁵,
wherein R⁵ is selected from the group comprising R¹, hydrogen, polyethylene glycoles, aromatic compounds, and C₁-C₄ alkyl, wherein the aromatic compounds and C₁-C₄ alkyl optionally comprise at least one substituent selected as OR⁶, wherein R⁶ is selected from the group comprising hydrogen and C₁-C₄ alkyl;
wherein preferably R⁵ is selected from the group comprising hydrogen and C₁-C₄ alkyl,
wherein more preferably R⁵ is selected from the group comprising hydrogen and C₁-C₃ alkyl,
wherein even more preferably R⁵ is selected from the group comprising hydrogen and C₁- or C₂ alkyl, and
wherein most preferably R⁵ is selected from the group comprising hydrogen and methyl.

3. An aqueous basic etching composition according to claim 1 or 2, wherein the functionalized urea, biuret and guanidine derivatives and/or salts thereof are selected as compounds having formula II and/or salts thereof, wherein Y is selected from the group comprising oxygen and NRR",
wherein R and R" are independently selected from the group comprising R¹, hydrogen, polyethylene glycoles, aromatic compounds, and C₁-C₄ alkyl, wherein the aromatic compounds and C₁-C₄ alkyl optionally comprise at least one substituent selected as OR⁶, wherein R⁶ is selected from the group comprising hydrogen and C₁-C₃ alkyl,
wherein preferably R and R" are independently selected from the group comprising hydrogen and C₁-C₄ alkyl,
wherein more preferably R and R" are independently selected from the group comprising hydrogen and C₁-C₃ alkyl,
wherein even more preferably R and R" are independently selected from the group comprising hydrogen and C₁- or C₂ alkyl, and
wherein most preferably R and R" are independently selected from the group comprising hydrogen and methyl.

4. An aqueous basic etching composition according to any one of the preceding claims, wherein R² is selected as hydrogen.

5. An aqueous basic etching composition according to any one of the preceding claims, wherein at least one of R¹ and R² is selected as alkyl compounds, which can be branched or unbranched, preferably as C₁-C₆ alkyl, more preferably as C₁-C₄ alkyl, even more preferably as C₂- or C₃ alkyl, and most preferably as isopropyl or isopentyl.

6. An aqueous basic etching composition according to any one of the preceding claims, wherein at least one of R¹ and R² is selected from the group comprising NH₂, NHR³ and NR³R⁴,
wherein R³ and R⁴ are independently selected from the group comprising C₁-C₁₆ alkyl, 5- to 16-membered aryl and 5- to 16-membered heteroaryl, optionally comprising at least one substituent selected from the group comprising OR⁶, wherein R⁶ is selected from the group comprising hydrogen and C₁-C₆ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein preferably R³ and R⁴ are independently selected from C₁-C₁₀ alkyl, 5- to 10-membered aryl and 5- to 10-membered heteroaryl, optionally comprising at least one substituent selected from the group comprising OR⁶,
wherein R⁶ is selected from the group comprising hydrogen and C₁-C₆ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein more preferably R³ and R⁴ are independently selected from the group comprising C₁-C₆ alkyl, 5- to 6-membered aryl and 5- to 6-membered heteroaryl, optionally comprising at least one substituent selected from the group comprising OR⁶, wherein R⁶ is selected from the group comprising hydrogen and C₁-C₃ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein even more preferably R³ and R⁴ are independently selected from the group comprising C₁-C₃ alkyl, phenyl, imidazole and pyridine, optionally comprising at least one substituent selected from the group comprising OR⁶, wherein R⁶ is selected from the group comprising hydrogen and C₁-C₃ alkyl, NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
wherein most preferably R³ and R⁴ are independently selected as C₁-C₃ alkyl, and
wherein even most preferably R³ and R⁴ are independently selected as methyl.

7. An aqueous basic etching composition according to any one of the preceding claims, wherein at least one of R¹ and R² is selected as nitrogen-comprising heteroaromatic compounds,
wherein preferably at least one of R¹ and R² is selected as 4- to 10-membered heteroaromatic compounds comprising from 1 to 4 nitrogen atoms, optionally comprising at least one substituent selected from the group comprising OR⁶ and C₁-C₄ alkyl, wherein R⁶ is selected from the group comprising hydrogen and C₁-C₃ alkyl;
wherein more preferably at least one of R¹ and R² is selected as 4- to 8-membered heteroaromatic compounds comprising from 1 to 3 nitrogen atoms, optionally comprising at least one substituent selected from the group comprising OR⁶ and C₁-C₃ alkyl, wherein R⁶ is selected from the group comprising hydrogen and C₁- or C₂ alkyl;
wherein even more preferably at least one of R¹ and R² is selected as 5- to 6-membered heteroaromatic compounds comprising from 1 to 2 nitrogen atoms, optionally comprising at least one substituent selected from the group comprising OR⁶ and C₁-C₆ alkyl, wherein R⁶ is selected from the group comprising hydrogen and C₁-C₆ alkyl;
wherein most preferably at least one of R¹ and R² is selected from the group comprising imidazole and pyridine, optionally comprising at least one substituent selected as C₁-C₆ alkyl; and
wherein even most preferably at least one of R¹ and R² is selected from the group comprising imidazole and pyridine, optionally comprising at least one substituent selected as C₁-C₃ alkyl.

8. An aqueous basic etching composition according to any one of the preceding claims, wherein n is an integer from 0 to 4, preferably 0, 1 or 3.

9. An aqueous basic etching composition according to any one of the preceding claims, wherein the functionalized urea, biuret and guanidine derivatives and/or salts thereof are selected as compounds having formula I and/or salts thereof, wherein X is selected from the group comprising oxygen and NH, wherein m is 3, wherein n is 0 or 3,
wherein R¹ is selected from the group comprising:
(a) NH₂, NHR³ and NR³R⁴, wherein R³ and R⁴ are independently selected as C₁-C₆ alkyl, preferably C₁-C₃ alkyl, more preferably methyl, optionally comprising one of the substituents selected from the group comprising NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
(b) 4- to 10-membered heteroaromatic compounds, preferably 5- to 6-membered heteroaromatic compounds, more preferably imidazole or pyridine, optionally comprising at least one substituent selected as C₁-C₆ alkyl; and
(c) C₁-C₆ alkyl, preferably C₁-C₄ alkyl, more preferably C₂ or C₃ alkyl, and most preferably isopropyl;
and wherein R² is selected from the group comprising:
(a) hydrogen;
(b) NH₂, NHR³ and NR³R⁴, wherein R³ and R⁴ are independently selected as C₁-C₆ alkyl, preferably C₁-C₃ alkyl, more preferably methyl, optionally comprising one of the substituents selected from the group comprising NR⁷R⁸, wherein R⁷ and R⁸ are both independently selected as hydrogen or C₁-C₆ alkyl, and NH-CO-NH-(CH₂)ₒ-NR⁹R¹⁰, wherein o is selected as an integer from 0 to 4, wherein R⁹ and R¹⁰ are both independently selected as hydrogen or C₁-C₆ alkyl;
(c) 4- to 10-membered heteroaromatic compounds, preferably 5- to 6-membered heteroaromatic compounds, more preferably imidazole or pyridine, optionally comprising at least one substituent selected as C₁-C₆ alkyl; and
(d) C₁-C₆ alkyl, preferably C₁-C₄ alkyl, more preferably C₂ or C₃ alkyl, and most preferably isopropyl.

10. An aqueous basic etching composition according to any one of the preceding claims, wherein the compounds having formulae I and II and/or salts thereof are present in the composition at a total concentration from 1 wt.-% to 15 wt.-% based on the total weight of the composition, preferably at a total concentration from 2 wt.-% to 14 wt.-%, more preferably from 3 wt.-% to 13 wt.-%, even more preferably from 4 wt.-% to 13 wt.-%, and most preferably from 5 wt.-% to 12.5 wt.-%.

11. An aqueous basic etching composition according to any one of the preceding claims, wherein the composition further comprises:
(iii) an anionic agent, which is selected as an acid or a metal salt of an acid, wherein preferably the acid is selected from the group comprising hydrochloric acid, sulfuric acid, bromic acid, carboxylic acids, more preferably acetic acid, alkyl sulfonic acid, more preferably methane sulfonic acid, aryl sulfonic acid, preferably tosylate compounds, and metal salts thereof.

12. An aqueous basic etching composition according to claim 11, wherein the composition comprises the anionic agent at a total concentration in a range from 1 wt.-% to 30 wt.-% based on the total weight of the composition, preferably in a range from 2 wt.-% to 25 wt.-%, more preferably in a range from 3 wt.-% to 20 wt.-%, even more preferably in a range from 5 wt.-% to 15 wt.-%, and most preferably at 10 wt.-%.

13. A method for treating a surface of a metal substrate, the method comprising the steps:
(A) providing said metal substrate,
(B) providing an aqueous basic etching composition for the treatment of surfaces of metal substrates according to any one of claims 1 to 12, and
(C) contacting the metal substrate with said aqueous basic etching composition such that the surface of the metal substrate is etched.

14. The method according to claim 13, wherein the method comprises the further step:
(D) recycling the aqueous basic etching composition after method step (C), wherein step (D) comprises the steps:
(D1) Increasing the temperature of the aqueous basic etching composition to obtain a temperature-increased aqueous basic etching composition,
(D2) Filtering the temperature-increased aqueous basic etching composition to obtain a filtered aqueous basic etching composition; and
(D3) Reapplying the filtered aqueous basic etching composition to method step (C).

15. A metal substrate with an etched surface, wherein the etched surface of the metal substrate has been obtained by a method for treating a surface of a metal substrate according to any one of claims 13 to 14.
